# FASCICULE DE BREVET EUROPEEN

(11) **EP 2 773 172 B1**
(45) Date de publication et mention de la délivrance du brevet: **09.02.2022**
(21) Numéro de dépôt: 14154793.5
(22) Date de dépôt: 12.02.2014
(51) Int. Cl.: H05K 7/20

(54) **Pluralité de dispositifs de refroidissement et répartiteur hydraulique**
Mehrzahl von Kühlungsvorrichtungen und hydraulischer Verteiler
Plurality of cooling devices and hydraulic distributor

(30) Priorité: 28.02.2013 FR 1351780
(43) Date de publication de la demande: 03.09.2014
(73) Titulaire: BULL SAS, 78340 Les Clayes sous Bois (FR)
(72) Inventeur: Demange, Fabien, 78300 Poissy (FR); Bonnin, Jean-Christophe, 78120 Rambouillet (FR)
(74) Mandataire: Camus, Olivier Jean-Claude

(56) Documents cités:
- US-A1- 2004 057 211
- US-A1- 2006 243 332
- US-A1- 2009 260 777
- US-A1- 2011 026 225
- US-A1- 2011 240 281

## Description

### DOMAINE TECHNIQUE DE L'INVENTION

L'invention se rapporte à un répartiteur hydraulique apte à distribuer un liquide caloporteur à une pluralité de dispositifs de refroidissement, en particulier des dispositifs de refroidissement de lames de calcul contenues dans une armoire informatique, ou dans un élément contenu dans une armoire.

On entendra par conduite d'entrée du liquide caloporteur dans le répartiteur dans le cadre de la présente demande une conduite permettant l'arrivée, depuis l'extérieur du répartiteur, du liquide caloporteur dans le répartiteur. Cette arrivée peut se faire au moyen d'un tuyau d'alimentation reliant la conduite d'entrée à un moyen de stockage externe au répartiteur du liquide caloporteur.

On entendra par conduite d'alimentation desdits dispositifs de refroidissement par le liquide caloporteur dans le cadre de la présente demande une conduite permettant de faire passer le liquide caloporteur depuis le répartiteur vers un desdits dispositifs de refroidissement.

On entendra par canal d'alimentation dans le cadre de la présente demande un canal interne au répartiteur dans lequel le liquide caloporteur peut circuler, ledit canal permettant au liquide caloporteur de circuler entre la conduite d'entrée et la pluralité de conduites d'alimentation.

On entendra par conduite de sortie du liquide caloporteur du répartiteur dans le cadre de la présente demande une conduite permettant la sortie du liquide caloporteur en dehors du répartiteur, une fois qu'il est passé dans les dispositifs de refroidissement. Cette sortie peut se faire au moyen d'un tuyau reliant la conduite de sortie à un moyen de stockage externe au répartiteur du liquide caloporteur où ce dernier sera par exemple refroidi ou évacué.

On entendra par conduite de retour du liquide caloporteur dans le répartiteur dans le cadre de la présente demande une conduite permettant de faire passer le liquide caloporteur depuis un desdits dispositifs de refroidissement vers le répartiteur.

On entendra par canal de retour dans le cadre de la présente demande un canal interne au répartiteur dans lequel le liquide caloporteur peut circuler, ledit canal permettant au liquide caloporteur de circuler entre la pluralité de conduites de retour et la conduite de sortie.

### ETAT DE LA TECHNIQUE ANTERIEURE

Les serveurs de calcul informatique sont constitués de processeurs, de mémoires et autres composants qui sont placés sur des lames de calcul, elles-mêmes enchâssées dans des châssis d'armoire informatique. Une armoire informatique standard comporte généralement plusieurs châssis (ou étagères) à l'intérieur desquels sont enchâssées une ou plusieurs lames de calcul.

Il est connu de refroidir les lames de calcul contenues au moyen de dispositif de refroidissement à air. Ainsi à l'avant d'un châssis comportant des lames de calcul, se trouvent des ventilateurs, l'air des ventilateurs est poussé sur des radiateurs situés sur les composants de la lame de calcul qui chauffent. L'air chaud qui ressort par l'arrière des serveurs est géré par le système de climatisation de la salle dans laquelle se trouvent les armoires de serveur. Un tel type de dispositif mis en place pour une armoire de calcul de 2m de haut permet d'avoir une armoire d'au maximum 20kW de puissance à dissiper, limitant de ce fait la puissance de calcul des serveurs.

Un autre dispositif connu de refroidissement des serveurs utilise le principe du refroidissement air/eau. A l'arrière des armoires est placé un échangeur air/eau. L'air passe à travers les serveurs, y récupère la chaleur dissipée par lesdits serveurs et ensuite transite par l'échangeur air/eau dans lequel de l'eau froide circule. L'eau froide circulant dans l'échangeur étant à une température d'environ 7°C en entrée pour 40kW et une température de salle de 26°C. Ceci permet d'avoir une température d'eau qui ressort de l'armoire égale à la température de l'air qui entre dans l'armoire. Ainsi, pour la climatisation du client, l'armoire est transparente vis-à-vis de la climatisation de la salle. Un tel dispositif permet d'augmenter la puissance pouvant être générée par l'armoire à 40kW maximum et dissipable par le dispositif de refroidissement air/eau. Cependant, un tel dispositif nécessite l'arrivée d'une eau froide ce qui n'est pas optimal du point de vue de l'efficacité énergétique car nécessitant dans la salle la présence de groupes frigorigènes avec compresseurs qui sont des éléments particulièrement énergivores. En outre, un tel dispositif limite encore la puissance dissipable de telles armoires informatiques à environ 40 kW, limitant en conséquent la puissance de calcul potentiellement disponible.

Par la suite, des systèmes de refroidissement entièrement hydraulique ont été développés, comme par exemple dans le document US 2009/260777 A1.

Ce type de système de refroidissement comporte une plaque froide disposée au-dessus des composants d'une lame de calcul, cette plaque froide étant parcourue par un circuit de refroidissement dans lequel circule un liquide caloporteur. Un tel dispositif comporte au moins une plaque froide captant la chaleur émise par des lames de calcul contenues dans l'armoire. Le liquide caloporteur circule dans chacune des plaques froides des lames de calcul et est ensuite redirigé vers un échangeur eau/eau commun aux lames de calcul. Du fait de la chaleur importante dégagée par les composants des lames de calcul, une eau à température « ambiante » suffit à leur refroidissement, au sens température dans la salle dans laquelle se trouvent les armoires de serveurs informatiques. Ainsi il n'est plus nécessaire d'avoir une eau froide ou un air chaud à évacuer et à refroidir, ce qui diminue de façon importante les coûts d'une telle installation. Cependant, ce type de refroidissement entièrement hydraulique pose des problèmes de maintenance. En effet, la liaison entre l'ensemble des plaques froides des lames de calcul, dispositifs de refroidissement, et l'échangeur eau/eau serait assurée dans le fond de l'armoire informatique et il serait nécessaire afin de démonter/remonter les lames de calcul d'accéder manuellement à l'arrière de l'armoire informatique afin de débrancher les moyens de connexion hydraulique entre les plaques froides et l'échangeur eau/eau. Cette contrainte en implique d'autres, à savoir : la nécessité dans la salle contenant les armoires informatiques d'aménager une place en vue de permettre l'accès à l'arrière des armoires informatiques et la perte de temps qu'implique cette action.

### EXPOSE DE L'INVENTION

L'invention vise à remédier aux inconvénients de l'état de la technique identifiés ci-dessus, et notamment à proposer des moyens compacts permettant de répartir sur des lames de calcul d'un châssis d'armoire informatique un débit de liquide caloporteur tout en garantissant un enfichage précis des lames de calcul dans le châssis.

Dans ce dessein, un aspect de l'invention se rapporte à une pluralité de diapositifs de refroidissement et à un répartiteur hydraulique distribuant un liquide caloporteur à la pluralité de dispositifs de refroidissement tels que des plaques froides, ledit répartiteur comportant :
- une conduite d'entrée du liquide caloporteur dans le répartiteur hydraulique ;
- une pluralité de conduites d'alimentation desdits dispositifs de refroidissement par le liquide caloporteur, chacune des conduites d'alimentation étant en liaison hydraulique avec la conduite d'entrée au moyen d'un canal d'alimentation ;
- une conduite de sortie du liquide caloporteur du répartiteur ;
- une pluralité de conduites de retour du liquide caloporteur dans le répartiteur, chacune des conduites de retour étant en liaison hydraulique avec la conduite de sortie au moyen d'un canal de retour.

Au moins une desdites conduites d'alimentation ou conduites de retour du liquide caloporteur comporte un connecteur flottant inséré dans ladite conduite, ledit connecteur flottant établissant une connexion hydraulique avec au moins un desdits dispositifs de refroidissement de la pluralité de dispositifs de refroidissement. D'une part, le canal d'alimentation du liquide caloporteur comporte une chicane, et d'autre part, ledit canal d'alimentation et le canal de retour du liquide caloporteur parcourent horizontalement le répartiteur et sont agencés l'un par rapport à l'autre de façon à ce que la conduite d'entrée et la conduite de sortie sont situées à une même extrémité du répartiteur hydraulique et l'alimentation en liquide caloporteur des dispositifs de refroidissement suit un schéma de type dernier entré/premier sorti (LIFO).

Le connecteur flottant permet l'établissement d'une connexion hydraulique entre la conduite d'alimentation ou conduite de retour et un desdits dispositifs de refroidissement.

Ainsi, le répartiteur hydraulique selon l'invention peut être facilement disposé dans le châssis au niveau de la carte fond de panier, et permettre la liaison entre des connecteurs hydrauliques disposés sur la carte fond de panier et des dispositifs de refroidissements de lames de calcul, par exemple des plaques froides, de façon à permettre la répartition du liquide caloporteur en arrivée dans le répartiteur entre les différents dispositifs de refroidissement. Sur la carte fond de panier, sont disposés des connecteurs de puissance et des connecteurs électriques analogiques/numériques qui sont montés très précisément sur la carte fond de panier et le positionnement du répartiteur doit se faire de façon précise par rapport à cette carte fond de panier, afin d'assurer l'enfichage précis des lames de calcul à la fois au répartiteur hydraulique et aux connecteurs électriques et de puissance de la carte fond de panier. L'utilisation de connecteurs flottants apporte le degré de liberté nécessaire à la connexion en aveugle des lames de calcul au répartiteur hydraulique intégré dans le châssis, tout en assurant la connexion adéquate des lames serveur de calcul-s aux connecteurs électroniques et de puissances de la carte fond de panier. La conduite d'alimentation ou conduite de retour adaptée pour recevoir un connecteur flottant est de dimensions supérieures aux dimensions du connecteur flottant. Les lames de calcul sont insérées dans le châssis et connectées à la fois aux connecteurs de puissance et électriques et aux connecteurs hydrauliques du répartiteur hydraulique. Le positionnement précis du répartiteur hydraulique, i.e. à l'intérieur du châssis, permet de connecter et déconnecter les lames de calcul en aveugle, sans intervention supplémentaire de la part de l'utilisateur.

Le débit de liquide caloporteur en entrée de la conduite d'entrée est réparti sur les différentes lames de calcul au moyen de la pluralité de conduites d'alimentation.

Un dispositif de refroidissement est destiné à être relié à la fois à une conduite d'alimentation du répartiteur et au moins une conduite de retour du répartiteur, afin que le dispositif de refroidissement puisse être alimenté en liquide caloporteur.

Par ailleurs, le canal d'alimentation du liquide caloporteur et le canal de retour du liquide caloporteur sont agencés l'un par rapport à l'autre de façon à ce que l'alimentation en liquide caloporteur des dispositifs suit un schéma de type dernier entré/premier sorti (LIFO). Ce type de schéma d'alimentation en liquide caloporteur permet d'assurer une répartition équilibrée du débit du liquide caloporteur entre les différents dispositifs de refroidissement devant être alimentés par ledit liquide caloporteur au moyen du répartiteur.

De plus, le canal d'alimentation et le canal de retour parcourent horizontalement le répartiteur, de sorte que la conduite d'entrée et la conduite de retour sont situées à une même extrémité du répartiteur et que le canal d'alimentation comporte une chicane. La chicane de la conduite d'alimentation permet d'assurer une alimentation selon un schéma dernier entré/premier sorti des dispositifs lorsque les conduites d'entrée et de retour sont disposées à une même extrémité du répartiteur hydraulique.

Outre les caractéristiques principales qui viennent d'être mentionnées dans le paragraphe précédent, le dispositif selon l'invention peut présenter une ou plusieurs caractéristiques complémentaires parmi les suivantes, considérées individuellement ou selon les combinaisons techniquement possibles :
- il existe un jeu mécanique entre un premier axe d'au moins ladite conduite d'alimentation ou conduite de retour du liquide caloporteur et un deuxième axe du connecteur flottant. Les connecteurs flottants destinés à s'enficher dans les conduites d'alimentation/de retour ont une liberté de mouvement du fait du jeu mécanique disponible, les conduites d'alimentation/de retour étant de dimension supérieure à la dimension attendue des connecteurs flottants afin de leur adjoindre cette liberté de mouvement/de flottaison. Les conduites d'alimentation/de retour et les connecteurs flottants étant des éléments cylindriques, on entend par axe desdits éléments leur axe de révolution. Il existe ainsi un jeu entre le premier axe de révolution de la conduite d'alimentation/de retour et le deuxième axe de révolution du connecteur flottant. C'est le moyen de maintien par pression qui garantit la flottaison du connecteur tout en conservant une étanchéité parfaite, par la maîtrise de la compression d'un moyen d'étanchéité du connecteur, par exemple un joint torique ;
- il comporte un moyen de maintien par pression du connecteur flottant auxdites conduite d'alimentation et conduite de retour du liquide caloporteur. Le moyen de maintien par pression peut par exemple être une plaque disposée sur une face du répartiteur hydraulique, face sur laquelle se trouve une pluralité de conduites d'alimentation et de retour. La plaque comporte autant d'ouvertures qu'il y a de conduites d'alimentation et de retour, et donc de connecteurs flottants. Les connecteurs flottants traversent lesdites ouvertures de façon à s'enficher dans les conduites d'alimentation et de retour du répartiteur afin d'assurer la connexion hydraulique des dispositifs de refroidissement au répartiteur hydraulique ;
- il comporte des moyens de fixation du moyen de maintien en butée mécanique. Les moyens de fixation du moyen de maintien peuvent être des vis traversant des ouvertures pratiquées dans le moyen de maintien de façon à ce que le serrage des vis assure le maintien en butée mécanique du moyen de maintien, par exemple une plaque, contre une face du répartiteur hydraulique sur laquelle se trouve au moins une conduite apte à recevoir un connecteur flottant ;
- la pluralité de conduites d'alimentation et la pluralité de conduites de retour du liquide caloporteur sont disposées sur une première face du répartiteur hydraulique ;
- une première partie de la pluralité de conduites d'alimentation et de la pluralité de conduites de retour du liquide caloporteur sont disposées sur une deuxième face du répartiteur hydraulique et en ce qu'une deuxième partie de la pluralité de conduites d'alimentation et de la pluralité de conduites de retour du liquide caloporteur sont disposées sur une troisième face du répartiteur hydraulique;
- les conduites d'alimentation et les conduites de retour d'une même face du répartiteur présentent des diamètres différents. Ceci permet d'assurer une répartition équilibrée du liquide caloporteur entre les dispositifs lorsque des dispositifs de refroidissement sont disposés en vis-à-vis par rapport au répartiteur hydraulique ; et
- il est constitué de deux corps, un premier corps comportant la conduite d'entrée du liquide caloporteur, la pluralité de conduites d'alimentation desdits dispositifs par le liquide caloporteur et le canal d'alimentation et un deuxième corps comportant la conduite de sortie du liquide caloporteur du répartiteur, la pluralité de conduites de retour du liquide caloporteur et le canal de retour.

L'invention concerne également un châssis d'armoire informatique comportant une pluralité de diapositifs de refroidissement et un répartiteur hydraulique selon l'un des modes de réalisation précédemment décrits.

### BREVE DESCRIPTION DES FIGURES

D'autres caractéristiques et avantages de l'invention ressortiront à la lecture de la description qui suit, en référence aux figures annexées, qui illustrent :
- la figure 1, une vue de l'intérieur d'un châssis d'une armoire informatique selon un mode de réalisation de l'invention ;
- la figure 2, un répartiteur hydraulique selon un mode de réalisation de l'invention ;
- la figure 3, une vue en coupe d'un répartiteur hydraulique selon un mode de réalisation de l'invention et d'un connecteur flottant ; et
- la figure 4, une modélisation du circuit hydraulique parcouru par un liquide caloporteur dans un répartiteur hydraulique selon le mode de réalisation de la figure 2.

Pour plus de clarté, les éléments identiques ou similaires sont repérés par des signes de référence identiques sur l'ensemble des figures.

### DESCRIPTION DETAILLEE D'UN MODE DE REALISATION

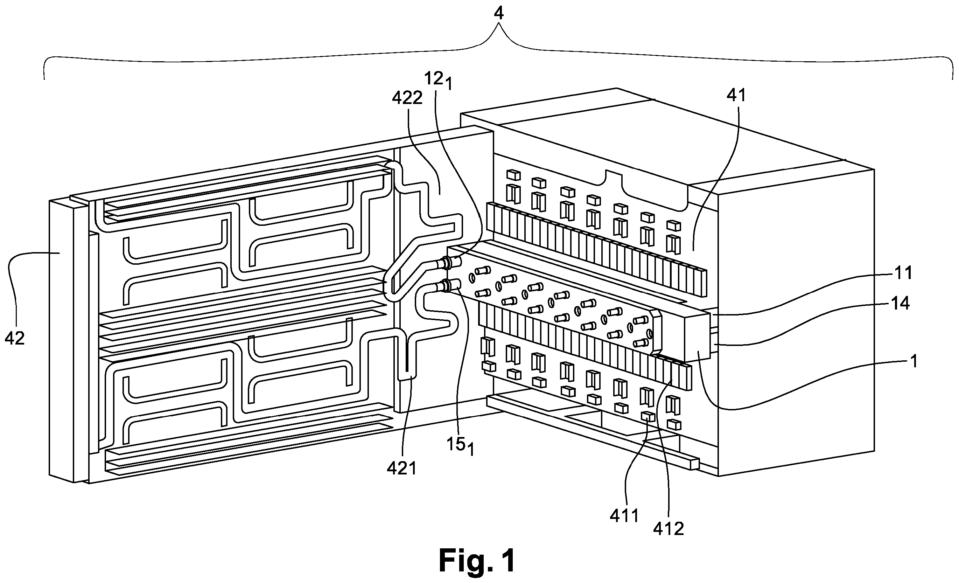

La figure 1 représente l'intérieur 4 d'un châssis ou serveur montable sur bâti, également appelé « server rack » en anglais. Ce châssis est amovible d'un bâti formant l'armoire informatique (non représenté sur la figure 1). Le châssis comporte une carte dite « fond de panier » 41 perpendiculaire à une lame de calcul 42. Le châssis peut comporter plusieurs lames de calcul, mais par souci de clarté une seule lame de calcul est représentée sur la figure 1. La lame de calcul 42 comporte une plaque froide 422 en aluminium. La plaque froide 422 comporte un réseau hydraulique 421 dans lequel circule un liquide caloporteur de façon à refroidir directement les composants situés sur la lame de calcul. Ce réseau hydraulique 421 forme un dispositif de refroidissement R1 relié à un répartiteur hydraulique 1 au moyen d'une conduite d'alimentation 12₁ et d'une conduite de retour 15₁. Le liquide caloporteur entre dans le répartiteur hydraulique 1 au moyen d'une conduite d'entrée 11 et en ressort au moyen d'une conduite de sortie 14. Le répartiteur hydraulique 1 est fixé à la carte de fond de panier.

La carte de fond de panier 41 comporte des connecteurs de puissance 411 et des connecteurs électriques 412 permettant d'interconnecter les lames de calcul entre elles et de les connecter à un réseau relié à l'armoire informatique comportant le châssis. Le répartiteur hydraulique 1 est également fixé à la carte fond de panier 41, il est ainsi intégré directement au cœur du châssis. Ceci permet de facilement monter et démonter les lames de calcul dans le châssis sans avoir à intervenir au niveau du répartiteur hydraulique 1. Afin de l'intégrer directement au cœur du châssis il a été nécessaire de réduire au maximum des dimensions du répartiteur permettant ainsi de l'intégrer dans le châssis sans prendre trop de place par rapport aux lames de calcul, et donc sans réduire la puissance de calcul potentielle du serveur. En outre, afin d'assurer une connexion et déconnexion des lames de calcul au répartiteur hydraulique sans fuite, il a été nécessaire d'intégrer des connecteurs hydrauliques sans fuite de liquide à la déconnexion et sans entrée d'air à la connexion et vice et versa.

D'un point de vue fonctionnement du répartiteur hydraulique dans un châssis d'armoire informatique, il est préférable à la connexion des lames de serveur que les lames de calcul et le répartiteur soient pré-remplis et sous pression.

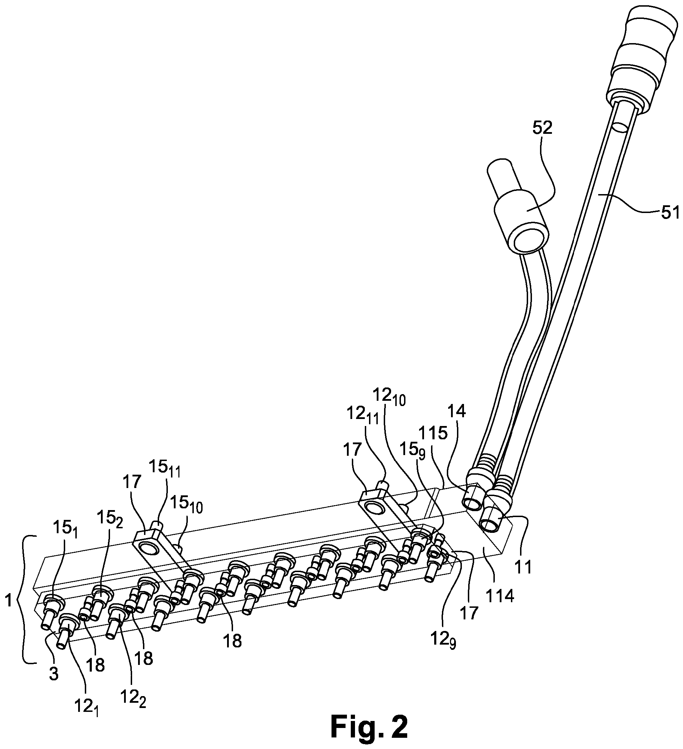

Le répartiteur hydraulique 1 va maintenant être décrit plus en détail en référence aux figures 2 à 4.

Dans cet exemple de réalisation, le répartiteur hydraulique comporte vingt-deux connecteurs hydrauliques, tels que visibles à la figure 2 :
- dix-huit connecteurs hydrauliques sur une deuxième face 114 du répartiteur 1 hydraulique pour connecter neuf lames de calcul au répartiteur hydraulique, les lames de calcul étant connectables de façon perpendiculaire au répartiteur 1 ; et
- quatre connecteurs hydrauliques sur une troisième face 115 du répartiteur 1 hydraulique pour connecter deux modules dits switch au répartiteur hydraulique de façon coplanaire au répartiteur.

Les dix-huit connecteurs hydrauliques de la deuxième face 114 du répartiteur 1 sont répartis en neuf conduites d'alimentation (12₁, ... 12₉) et neuf conduites de retour (15₁, ..., 15₉) afin d'alimenter en liquide caloporteur les neuf lames de calcul enfichables. Les quatre connecteurs hydrauliques de la troisième face 115 du répartiteur 1 sont répartis en deux conduites de retour (15₁₀, 15₁₁) et deux conduites d'alimentation (12₁₀, 12₁₁₎ afin d'alimenter en liquide caloporteur les deux modules switch.

Le répartiteur hydraulique 1 comporte une conduite d'entrée 11 et une conduite de sortie 14 permettent d'alimenter en liquide caloporteur le répartiteur 1, la conduite d'entrée 11 étant reliée à un tuyau d'alimentation 51 en liquide caloporteur et la conduite de sortie 14 étant reliée à un tuyau de sortie 52 du liquide caloporteur. Le sens de circulation du liquide dans le répartiteur n'a pas d'influence spécifique sur le refroidissement des dispositifs de refroidissement pouvant être reliés au répartiteur 1.

La conduite d'alimentation 12₁ et la conduite de retour 15₁ reçoivent chacune un connecteur flottant 3 permettant de relier en aveugle lesdites conduites d'alimentation 12₁ et de retour 15₁ à un dispositif de refroidissement d'une lame de calcul, par exemple, auquel le répartiteur hydraulique 1 distribue un liquide caloporteur afin de refroidir les composants de la lame de calcul en fonctionnement. Le répartiteur hydraulique 1 comporte trois moyens de maintien 17, qui sont des plaques, permettant de maintenir par pression les connecteurs flottants 3 insérés dans chacune des conduites d'alimentation (12₁, ... 12₁₁) et de retour (15₁, ... 15₁₁). Ces moyens de maintien par pression mécanique permettent de limiter les risques de fuites du liquide caloporteur au niveau des connecteurs flottants. Ces plaques 17 comportent autant d'ouverture que de connecteurs flottants à maintenir par pression dans les conduites d'alimentation et de retour du répartiteur hydraulique. Une fois, les plaques 17 en place, elles peuvent être fixées au répartiteur hydraulique 1 au moyen des moyens de fixation 18, du type vis, permettant de fixer les plaques 17 en butée mécanique contre le répartiteur hydraulique 1.

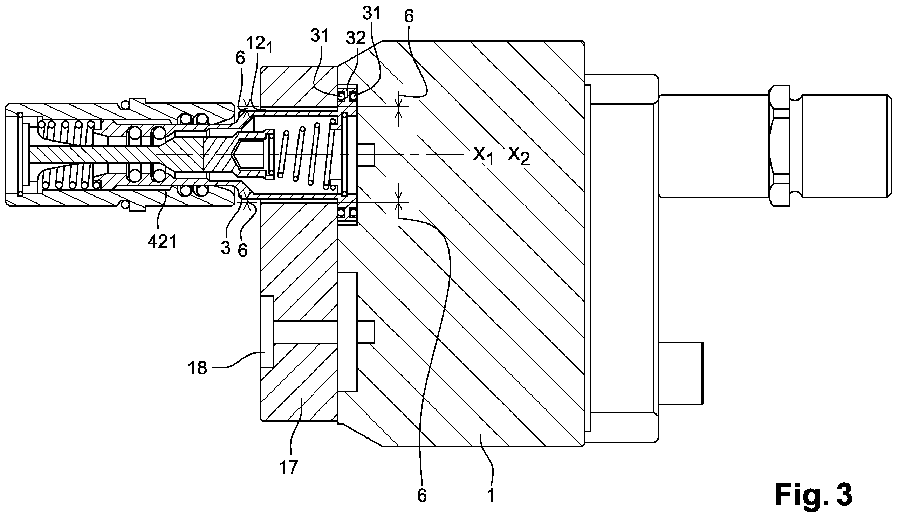

Afin de pouvoir recevoir un connecteur flottant 3 et ainsi pouvoir assurer une connexion en aveugle des lames de calcul et de leur dispositif de refroidissement dans le châssis d'une armoire informatique, les conduites d'alimentation et/ou de retour du répartiteur hydraulique sont agencées de façon à assurer la présence d'un jeu mécanique entre un premier axe de ladite conduite et un deuxième axe du connecteur flottant. Le jeu mécanique est plus particulièrement visible à la figure 3. Le répartiteur hydraulique 1 comporte une conduite d'alimentation 12₁, à l'extrémité de laquelle se trouve un orifice dans laquelle est logé un connecteur flottant 3. On parle ici de connecteur flottant 3 mais il s'agit plus particulièrement de la partie mâle de la connexion, la partie femelle étant fixée sur une lame de calcul. Lors de son insertion dans le châssis d'une armoire informatique comportant le répartiteur hydraulique 1, la lame de calcul doit être connectée hydrauliquement au système de refroidissement de l'armoire informatique. Pour ce faire, elle possède au moins un connecteur de lame de calcul 423, visible en coupe à la figure 3. Ce connecteur de lame de calcul 423 est connectable au connecteur flottant 3, qui lui-même se connecte à la conduite d'alimentation 12₁ du répartiteur. Afin d'obtenir un degré de liberté lors de la connexion de la lame de calcul, via la connexion du connecteur de lame de calcul 423 à une extrémité du connecteur flottant 3, les dimensions de la conduite d'alimentation et de son orifice d'alimentation sont supérieures à celle du connecteur flottant 3 afin qu'il existe un jeu mécanique 6 entre un premier axe X1 de la conduite d'alimentation et un deuxième axe X2 du connecteur flottant. Ce jeu se traduit par un degré de flottaison 6 entre les bords externes du connecteur flottant 3 et les bords internes de la conduite d'alimentation 12₁. Ce jeu mécanique, ou degré de flottaison permet d'assurer le degré de liberté suffisant permettant de recentrer le connecteur flottant hydraulique à la connexion de la lame de calcul et de son dispositif de refroidissement. Ainsi si le connecteur flottant n'est pas parfaitement en face de la conduite d'alimentation ou de retour à laquelle il doit se connecter, il pourra automatiquement se recentrer du fait du jeu mécanique disponible. Le moyen de maintien 17 du connecteur flottant 3 par pression permet de limiter les risques de fuite au niveau de la liaison entre le connecteur flottant 3 et la conduite d'alimentation 121 en exerçant une pression sur le connecteur flottant 3 et sur des moyens d'étanchéité 31 du connecteur flottant disposés de chaque côté d'un épaulement 32 du connecteur flottant 3, garantissant ainsi la flottaison du connecteur flottant tout en conservant une étanchéité parfaite par la maîtrise de la compression du moyen d'étanchéité 31, du type joint torique par exemple. La vis 18 est un moyen de fixation 18 du moyen de maintien 17 au répartiteur hydraulique 1. Un épaulement 32 est maintenu par pression, via les moyens d'étanchéité 31, entre la plaque 17 et la face du répartiteur 1.

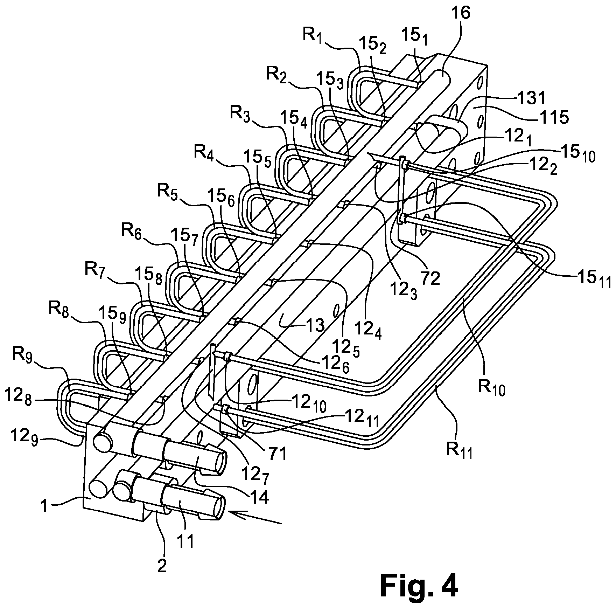

La figure 4 est une représentation de la modélisation du circuit hydraulique parcouru par le liquide caloporteur 2 alimentant les dispositifs de refroidissement (R1, ..., R9) de neuf lames de calcul connectés perpendiculairement au répartiteur 1 et les dispositifs de refroidissement (R10, R11) de deux modules switch connectés parallèlement ou de façon coplanaire au répartiteur, tel que décrit précédemment en référence à la figure 2. Le répartiteur hydraulique 1 comporte une conduite d'entrée 11 par laquelle arrive le liquide caloporteur, située dans la partie inférieure du répartiteur dans cet exemple de réalisation et une conduite de sortie 14 par laquelle le liquide caloporteur ressort du répartiteur une fois distribué aux différents dispositifs de refroidissements (R1,..., R11).

Une fois entré dans le répartiteur hydraulique 1 au moyen de la conduite d'entrée 11, le liquide caloporteur 2 parcourt un canal d'alimentation 13 qui parcourte horizontalement le répartiteur 1. Ce canal d'alimentation 13 assure la liaison hydraulique entre la conduite d'entrée 11 et les onze conduite d'alimentation (12₁,..., 12₁₁) permettant d'alimenter en liquide caloporteur les dispositifs de refroidissements (R1,..., R11) pouvant être reliés au répartiteur 1.

Une fois que le liquide caloporteur 2 a parcouru les dispositifs de refroidissements (R1,..., R11), il retourne dans le répartiteur 1 au moyen des onze conduites de retour (15₁,..., 15₁₁), parcourte le canal de retour 16 qui parcourte horizontalement le répartiteur 1 et ressort du répartiteur au moyen de la conduite de sortie 14.

Il est bien visible sur la figure 4 que lea dispositif de refroidissement R1 est le premier à être sur le chemin en alimentation du liquide caloporteur via le canal d'alimentation 13 par rapport à la conduite d'entrée 11, mais le dernier sur le chemin en retour du liquide caloporteur via le canal de retour 16 par rapport à la conduite de sortie 14 : le schéma d'alimentation est du type LIFO dernier entré/premier sorti. Ce schéma d'alimentation permet d'avoir une perte de charge constante entre les différents dispositifs de refroidissement d'une même face du répartiteur hydraulique, le chemin parcouru par le liquide caloporteur est équivalent entre les différents dispositifs de refroidissement : ainsi le débit de liquide caloporteur traversant les différents dispositifs de refroidissement est constant. Ce schéma d'alimentation assure un équilibrage des débits en liquide caloporteur entre les différents dispositifs de refroidissement connectés au répartiteur hydraulique. C'est la chicane 131 du canal d'alimentation qui assure ce schéma d'alimentation malgré le fait que la conduite d'entrée 11 et la conduite de sortie 14 soient situées à une même extrémité du répartiteur.

La connexion des deux dispositifs de refroidissement R10, R11 situés sur la troisième face 115 du répartiteur hydraulique 1 qui sont horizontaux nécessite un arrangement du circuit. En effet, pour ce qui est des neuf dispositifs de refroidissement (R1,...,R9) permettant le refroidissement des neuf lames de calcul situées sur la deuxième face 114 du répartiteur hydraulique, du fait de leur perpendicularité par rapport au répartiteur hydraulique 1, l'entrée du liquide caloporteur dans ces dispositifs de refroidissement R1,...,R9 se trouve en face du canal d'alimentation 13 et la sortie du liquide caloporteur de ces dispositifs de refroidissement R1,...R9 se trouve en face du canal de retour 16. Cependant, pour ce qui est des deux dispositifs de refroidissement horizontaux de la troisième face du répartiteur, un croisement a dû être effectué en effectuant des perçages de conduites hydrauliques supplémentaires en interne afin d'alimenter ces dispositifs de refroidissement. Une première division hydraulique 71 permet de mettre le dispositif de refroidissement supérieur R₁₀ en connexion hydraulique avec le canal d'alimentation 13 qui traverse horizontalement la partie inférieure du répartiteur hydraulique et une deuxième division hydraulique 72 permet de mettre le dispositif de refroidissement inférieur R₁₁ en connexion hydraulique avec le canal de retour 16 qui traverse horizontalement la partie supérieure du répartiteur hydraulique.

Le diamètre des différentes conduites d'alimentation et conduites de retour peut être différent. Ainsi entre les conduites de retour 152 du deuxième dispositif de refroidissement R2 et 153 du troisième dispositif de refroidissement R3 se trouve la conduite de retour commune aux dispositifs de refroidissement de la troisième face 115 du répartiteur. Ceci peut créer une variation de pression du liquide caloporteur qui doit être compensée en augmentant le diamètre de la conduite de retour du troisième dispositif de refroidissement R3.

Le répartiteur aurait pu comporter un premier corps et un deuxième corps, le premier corps comportant la partie alimentation en liquide caloporteur des dispositifs de refroidissement, à savoir : la conduite d'entrée du liquide caloporteur, la pluralité de conduites d'alimentation desdits dispositifs par le liquide caloporteur et le canal d'alimentation et le deuxième corps comportant la partie retour du liquide caloporteur depuis les dispositifs de refroidissement, à savoir : la conduite de sortie du liquide caloporteur du répartiteur, la pluralité de conduites de retour du liquide caloporteur et le canal de retour.

L'invention n'est pas limitée aux modes de réalisation précédemment décrits en référence aux figures et des variantes pourraient être envisagées sans sortir du cadre de l'invention.

## Revendications

1. Une pluralité de dispositifs de refroidissement (R1, R2, ..., Rn) et un répartiteur hydraulique (1) distribuant un liquide caloporteur à une pluralité de dispositifs de refroidissement (R1, R2, ..., Rn), ledit répartiteur comportant :
- une conduite d'entrée (11) du liquide caloporteur dans le répartiteur hydraulique (1) ;
- une pluralité de conduites d'alimentation (12₁,..., 12ₙ) desdits dispositifs de refroidissement par le liquide caloporteur, chacune des conduites d'alimentation étant en liaison hydraulique avec la conduite d'entrée au moyen d'un canal d'alimentation (13) ;
- une conduite de sortie (14) du liquide caloporteur du répartiteur ;
- une pluralité de conduites de retour (15₁,..., 15ₙ) du liquide caloporteur dans le répartiteur, chacune des conduites de retour étant en liaison hydraulique avec la conduite de sortie au moyen d'un canal de retour (16) ;
- une alimentation en liquide caloporteur des dispositifs de refroidissement suivant un schéma de type dernier entré/premier sorti ; **caractérisés en ce qu'**au moins une desdites conduites d'alimentation ou conduites de retour du liquide caloporteur comporte un connecteur flottant (3) inséré dans ladite conduite, ledit connecteur flottant établissant une connexion hydraulique avec au moins un desdits dispositifs de refroidissement de la pluralité de dispositifs de refroidissement, et
**en ce que**, d'une part, le canal d'alimentation du liquide caloporteur (13) comporte une chicane (131), d'autre part, ledit canal d'alimentation et le canal de retour du liquide caloporteur (16) parcourent horizontalement le répartiteur et sont agencés l'un par rapport à l'autre de façon à ce que la conduite d'entrée (11) et la conduite de sortie (14) sont situées à une même extrémité du répartiteur hydraulique (1) .

2. Une pluralité de dispositifs de refroidissement (R1, R2, ..., Rn) et un répartiteur hydraulique (1) selon la revendication 1, **caractérisés en ce qu'**il existe un jeu mécanique entre un premier axe (X1) d'au moins ladite conduite d'alimentation ou conduite de retour du liquide caloporteur et un deuxième axe (X2) du connecteur flottant.

3. Une pluralité de dispositifs de refroidissement (R1, R2, ..., Rn) et un répartiteur hydraulique (1) selon l'une quelconque des revendications précédentes, **caractérisés en ce que** le répartiteur hydraulique comporte un moyen de maintien (17) par pression du connecteur flottant à au moins ladite conduite d'alimentation ou conduite de retour du liquide caloporteur.

4. Une pluralité de dispositifs de refroidissement (R1, R2, ..., Rn) et un répartiteur hydraulique (1) selon la revendication 3, **caractérisés en ce que** le répartiteur hydraulique comporte des moyens de fixation (18) du moyen de maintien (17) en butée mécanique.

5. Une pluralité de dispositifs de refroidissement (R1, R2, ..., Rn) et un répartiteur hydraulique (1) selon l'une quelconque des revendications précédentes, **caractérisés en ce que** la pluralité de conduites d'alimentation et la pluralité de conduites de retour du liquide caloporteur sont disposées sur une même face du répartiteur hydraulique.

6. Une pluralité de dispositifs de refroidissement (R1, R2, ..., Rn) et un répartiteur hydraulique (1) selon l'une quelconque des revendications 1 à 4, **caractérisés en ce qu'**une première partie de la pluralité de conduites d'alimentation et de la pluralité de conduites de retour du liquide caloporteur sont disposées sur une face du répartiteur hydraulique (1) et **en ce qu'**une deuxième partie de la pluralité de conduites d'alimentation et de la pluralité de conduites de retour du liquide caloporteur sont disposées sur une autre face du répartiteur hydraulique (1).

7. Une pluralité de dispositifs de refroidissement (R1, R2, ..., Rn) et un répartiteur hydraulique (1) selon la revendication précédente, **caractérisés en ce que** les conduites d'alimentation et les conduites de retour d'une même face du répartiteur présentent des diamètres différents.

8. Une pluralité de dispositifs de refroidissement (R1, R2, ..., Rn) et un répartiteur hydraulique (1) selon l'une quelconque des revendications précédentes, **caractérisés en ce que** le répartiteur hydraulique est constitué de deux corps, un premier corps comportant la conduite d'entrée du liquide caloporteur, la pluralité de conduites d'alimentation desdits dispositifs par le liquide caloporteur et le canal d'alimentation et un deuxième corps comportant la conduite de sortie du liquide caloporteur du répartiteur, la pluralité de conduites de retour du liquide caloporteur et le canal de retour.

9. Châssis d'armoire informatique comportant une pluralité de dispositifs de refroidissement (R1, R2, ..., Rn) et un répartiteur hydraulique (1) selon l'une quelconque des revendications précédentes.

## Patentansprüche

1. Vielzahl von Kühlvorrichtungen (R1, R2, ..., Rn) und hydraulischer Verteiler (1), der eine Wärmeübertragungsflüssigkeit an eine Vielzahl von Kühlvorrichtungen (R1, R2, ..., Rn) verteilt, wobei der Verteiler Folgendes umfasst:
- eine Einlassleitung (11) für die Wärmeübertragungsflüssigkeit in den hydraulischen Verteiler (1);
- eine Vielzahl von Leitungen zur Versorgung (12₁, ..., 12ₙ) der Kühlvorrichtungen mit der Wärmeübertragungsflüssigkeit, wobei jede der Versorgungsleitungen über einen Versorgungskanal (13) in hydraulischer Verbindung mit der Einlassleitung steht;
- eine Auslassleitung (14) für die Wärmeübertragungsflüssigkeit aus dem Verteiler;
- eine Vielzahl von Rücklaufeitungen (15₁, ..., 15ₙ) für die Wärmeübertragungsflüssigkeit in den Verteiler, wobei jede der Rücklaufleitungen über einen Rücklaufkanal (16) in hydraulischer Verbindung mit der Auslassleitung steht;
- eine Versorgung der Kühlvorrichtungen mit Wärmeübertragungsflüssigkeit nach einem Last-in/First-out-Schema;
**dadurch gekennzeichnet, dass** mindestens eine der Versorgungsleitungen oder Rücklaufleitungen für die Wärmeübertragungsflüssigkeit ein schwimmendes Verbindungsstück (3) aufweist, das in die Leitung eingesetzt ist, wobei das schwimmende Verbindungsstück eine hydraulische Verbindung mit mindestens einer der Kühlvorrichtungen aus der Vielzahl von Kühlvorrichtungen herstellt, und
dass einerseits der Versorgungskanal für die Wärmeübertragungsflüssigkeit (13) eine Blende (131) aufweist, andererseits der Versorgungskanal und der Rücklaufkanal für die Wärmeübertragungsflüssigkeit (16) den Verteiler horizontal durchlaufen und so zueinander angeordnet sind, dass sich die Einlassleitung (11) und die Auslassleitung (14) an einem selben Ende des hydraulischen Verteilers (1) befinden.

2. Vielzahl von Kühlvorrichtungen (R1, R2, ..., Rn) und hydraulischer Verteiler (1) nach Anspruch 1, **dadurch gekennzeichnet, dass** es ein mechanisches Spiel zwischen einer ersten Achse (X1) von mindestens der Versorgungsleitung oder Rücklaufleitung für die Wärmeübertragungsflüssigkeit und einer zweiten Achse (X2) des schwimmenden Verbindungsstücks gibt.

3. Vielzahl von Kühlvorrichtungen (R1, R2, Rn) und hydraulischer Verteiler (1) nach einem der vorstehenden Ansprüche, **dadurch gekennzeichnet, dass** der hydraulische Verteiler ein Mittel zum Halten (17) des schwimmenden Verbindungsstücks durch Druck an mindestens der Versorgungsleitung oder Rücklaufleitung für die Wärmeübertragungsflüssigkeit umfasst.

4. Vielzahl von Kühlvorrichtungen (R1, R2, Rn) und hydraulischer Verteiler (1) nach Anspruch 3, **dadurch gekennzeichnet, dass** der hydraulische Verteiler Mittel zum Befestigen (18) des Mittels zum Halten (17) mit mechanischem Anschlag aufweist.

5. Vielzahl von Kühlvorrichtungen (R1, R2, ..., Rn) und hydraulischer Verteiler (1) nach einem der vorstehenden Ansprüche, **dadurch gekennzeichnet, dass** die Vielzahl von Versorgungsleitungen und die Vielzahl von Rücklaufleitungen für die Wärmeübertragungsflüssigkeit auf einer selben Seite des hydraulischen Verteilers angeordnet sind.

6. Vielzahl von Kühlvorrichtungen (R1, R2, ..., Rn) und hydraulischer Verteiler (1) nach einem der Ansprüche 1 bis 4, **dadurch gekennzeichnet, dass** ein erster Teil der Vielzahl von Versorungsleitungen und der Vielzahl von Rücklaufleitungen für die Wärmeübertragungsflüssigkeit auf einer Seite des hydraulischen Verteilers (1) angeordnet sind und dass ein zweiter Teil der Vielzahl von Versorgungsleitungen und der Vielzahl von Rücklaufleitungen für die Wärmeübertragungsflüssigkeit auf einer anderen Seite des hydraulischen Verteilers (1) angeordnet sind.

7. Vielzahl von Kühlvorrichtungen (R1, R2, ..., Rn) und hydraulischer Verteiler (1) nach vorstehendem Anspruch, **dadurch gekennzeichnet, dass** die Versorgungsleitungen und die Rücklaufleitungen auf einer selben Seite des Verteilers unterschiedliche Durchmesser aufweisen.

8. Vielzahl von Kühlvorrichtungen (R1, R2, ..., Rn) und hydraulischer Verteiler (1) nach einem der vorstehenden Ansprüche, **dadurch gekennzeichnet, dass** der hydraulische Verteiler aus zwei Körpern besteht, wobei ein erster Körper die Einlassleitung für die Wärmeübertragungsflüssigkeit, die Vielzahl von Leitungen zur Versorgung der Vorrichtungen mit der Wärmeübertragungsflüssigkeit und den Versorgungskanal umfasst, und ein zweiter Körper die Auslassleitung für die Wärmeübertragungsflüssigkeit aus dem Verteiler, die Vielzahl von Rücklaufleitungen für die Wärmeübertragungsflüssigkeit und den Rücklaufkanal umfasst.

9. Rahmen für einen Datenverarbeitungsschrank mit einer Vielzahl von Kühlvorrichtungen (R1, R2, ..., Rn) und einem hydraulischen Verteiler (1) nach einem der vorstehenden Ansprüche.

## Claims

1. A plurality of cooling devices (R1, R2, ..., Rn) and a hydraulic distributor (1) distributing a coolant fluid to a plurality of cooling devices (R1, R2, ..., Rn), said distributor comprising:
- an inlet conduit (11) of the coolant fluid into the hydraulic distributor (1);
- a plurality of supply conduits (12₁, ..., 12ₙ) of said cooling devices by the coolant fluid, each of the supply conduits being hydraulically connected with the inlet conduit by means of a supply channel (13);
- an outlet conduit (14) of the coolant fluid from the distributor;
- a plurality of return conduits (15₁, ..., 15ₙ) of the coolant fluid into the distributor, each of the return conduits being hydraulically connected with the outlet conduit by means of a return channel (16);
- a supply of coolant fluid for the cooling devices according to a last in/first out type scheme;
**characterized in that** at least one of said coolant fluid supply conduits or return conduits comprises a floating connector (3) inserted into the conduit, said floating connector establishing a hydraulic connection with at least one of said cooling devices among the plurality of cooling devices, and
**in that**, on the one hand, the coolant fluid supply channel (13) comprises a baffle (131), on the other hand, said coolant fluid supply channel and return channel (16) pass through the distributor horizontally and are arranged with respect to one another in such a way that the inlet conduit (11) and the outlet conduit (14) are located at a same end of the hydraulic distributor (1).

2. A plurality of cooling devices (R1, R2, ..., Rn) and a hydraulic distributor (1) according to claim 1, **characterized in that** there is a mechanical clearance between a first axis (X1) of at least said coolant fluid supply conduit or return conduit and a second axis (X2) of the floating connector.

3. A plurality of cooling devices (R1, R2, ..., Rn) and a hydraulic distributor (1) according to any of the preceding claims, **characterized in that** the hydraulic distributor comprises a means (17) of holding by pressure the floating connector to at least the coolant fluid supply conduit or return conduit.

4. A plurality of cooling devices (R1, R2, ..., Rn) and a hydraulic distributor (1) according to claim 3, **characterized in that** the hydraulic distributor comprises means (18) of attaching the holding means (17) in mechanical abutment.

5. A plurality of cooling devices (R1, R2, ..., Rn) and a hydraulic distributor (1) according to any one of the preceding claims, **characterized in that** the plurality of supply conduits and the plurality of return conduits of the coolant fluid are arranged on a same face of the hydraulic distributor.

6. A plurality of cooling devices (R1, R2, ..., Rn) and a hydraulic distributor (1) according to any one of claims 1 to 4, **characterized in that** a first portion of the plurality of supply conduits and of the plurality of return conduits of the coolant fluid are arranged on one face of the hydraulic distributor (1) and **in that** a second portion of the plurality of supply conduits and of the plurality of return conduits of the coolant fluid are arranged on another face of the hydraulic distributor (1).

7. A plurality of cooling devices (R1, R2, ..., Rn) and a hydraulic distributor (1) according to the preceding claim, **characterized in that** the supply conduits and the return conduits on a same face of the distributor have different diameters.

8. A plurality of cooling devices (R1, R2, ..., Rn) and a hydraulic distributor (1) according to any one of the preceding claims, **characterized in that** the hydraulic distributor is composed of two bodies, a first body comprising the coolant fluid inlet conduit, the plurality of supply conduits of said devices by the coolant fluid and the supply channel, and a second body comprising the outlet conduit of the coolant fluid from the distributor, the plurality of coolant fluid return conduits and the return channel.

9. A computer cabinet rack comprising a plurality of cooling devices (R1, R2, ..., Rn) and a hydraulic distributor (1) according to any one of the preceding claims.
